Europäisches Patentamt

**European Patent Office**

Office européen des brevets

(19)

(11) Veröffentlichungsnummer: **0 007 384**
**B1**

(12) **EUROPÄISCHE PATENTSCHRIFT**

(45) Veröffentlichungstag der Patentschrift:
**27.07.83**

(51) Int. Cl.³: **H 04 N 3/14, H 01 J 29/45,**
**H 01 L 31/10**

(21) Anmeldenummer: **79100610.9**

(22) Anmeldetag: **01.03.79**

(54) **Eindimensionaler CCD-Sensor mit Überlaufvorrichtung.**

(30) Priorität: **28.03.78 DE 2813254**

(43) Veröffentlichungstag der Anmeldung:
**06.02.80 Patentblatt 80/3**

(45) Bekanntmachung des Hinweises auf die Patenterteilung:
**27.07.83 Patentblatt 83/30**

(84) Benannte Vertragsstaaten:
**BE CH FR GB IT NL**

(56) Entgegenhaltungen:
**DE-A-2 334 116**
**DE-A-2 602 800**
**DE-B-2 553 633**
**DE-B-2 553 686**
**RCA Review, Band 35, Nr. 1, März 1974, Princeton, New Jersey, USA, W. F. KOSONOCKY et al. »Control of Blooming in Charge-Coupled Imagers« Seiten 3 bis 24**

(73) Patentinhaber: **SIEMENS AKTIENGESELLSCHAFT, Berlin und München Wittelsbacherplatz 2, D-8000 München 2 (DE)**

(72) Erfinder: **Herbst, Heiner, Dr., Am See 2, D-8013 Haar (DE)**

# Eindimensionaler CCD-Sensor mit Überlaufvorrichtung

Die Erfindung betrifft einen optoelektronischen Sensor mit Überlaufvorrichtung, enthaltend eine auf einem dotierten Halbleiterkörper vom ersten Leitungstyp angeordnete Reihe von Sensorelementen aus MIS-Kondensatoren zur Sammlung optisch erzeugter Minoritätsträger, die gegeneinander getrennt sind durch Mittel zur Erzeugung einer Potentialschwelle für die Minoritätsträger im Halbleiterkörper, mindestens ein von weiteren MIS-Kondensatoren gebildetes Schieberegister auf jeder Seite der Sensorreihe und seitlich an den Sensorelektroden angeordnete Übertragungselektroden, die nach dem Prinzip der Ladungskopplung die Sensorelemente abwechselnd mit einem Kondensator der beiden Schieberegister verbinden, sowie Überlaufgebiete, die über Fenster in der Isolierschicht mit einer Überlaufelektrode kontaktiert sind, und Mittel, die zwischen den Überlaufgebieten und den Sensorelementen eine gegenüber der Potentialschwelle zwischen den Sensorelementen selbst geringere Potentialschwelle für die Minoritätsträger erzeugen, wobei die Oberfläche des Halbleiterkörpers seitlich an jedem Sensorelement ein Überlaufgebiet vom zweiten Leitungstyp enthält, das sich an der zur zugehörigen Übertragungselektrode entgegengesetzten Seite des Sensorelementes erstreckt.

Eindimensionale optoelektronische Sensoren enthalten in einer Reihe angeordnete Sensorelemente, die in der Lage sind, die Intensität des auf sie fallenden Lichtes in ein elektrisches Signal umzusetzen. Sie werden z. B. zum Abtasten der linearen Abmessungen von Gegenständen, z. B. Werkstücken in der Fertigung, oder auch zum zeilenweisen Abtasten elektronisch zu erfassender Bilder, z. B. bei der Faksimile-Übertragung, angewendet.

Als Sensorelemente werden in zunehmendem Maße Metallelektrode/Isolator/Halbleiter-(MIS-)Kondensatoren verwendet, die aus einem mit einer Isolierschicht bedeckten dotierten Halbleiterkörper und einer lichtdurchlässigen, darüberliegenden »Metallelektrode« (üblicherweise aus stark dotiertem Polysilizium) bestehen. Wird nun z. B. bei p-dotiertem Halbleitersubstrat der Substratanschluß des MIS-Kondensators gegenüber der Elektrode negativ vorgespannt, so werden die (positiven) Majoritätsträger des Substrats vom Substratanschluß abgezogen, während die optisch erzeugten Minoritätsträger unter der Sensorelektrode gehalten werden. Dieses Ladungspaket aus Minoritätsträgern kann periodisch dadurch in ein aus weiteren MIS-Kondensatoren gebildetes Schieberegister ausgelesen werden, daß über der Isolierschicht zwischen der Sensorelektrode und der Elektrode eines Schieberegister-Kondensators eine Übertragungselektrode (Transfer-Gate) angeordnet wird, die, nur durch eine dünne Oxidschicht isoliert, unmittelbar an die beiden Elektroden anschließt bzw. diese geringfügig überlappt.

Wird das Transfer-Gate gegenüber dem Substratanschluß auf negatives Potential gelegt, so entsteht für die optisch erzeugten negativen Ladungsträger (Minoritätsträger) eine Potentialschwelle, die den Übertritt der Minoritätsträger aus dem Sensorelement in das Schieberegister während des Sammelns der optisch erzeugten Ladungsträger verhindert.

Wird jedoch das Transfer-Gate auf genügend positives Potential gelegt, so entsteht ein Potentialgefälle für die Minoritätsträger vom Sensorelement in den Halbleiterbereich unter dem Transfer-Gate und die Ladung fließt dahin ab. Auf gleiche Weise können die Ladungsträger sodann weiter in den Kondensator des Schieberegisters verschoben werden (Charge-coupleddevice, Prinzip der Ladungskopplung).

Für eine möglichst naturgetreue Erfassung des Bildes ist es erforderlich, eine möglichst hohe Anzahl von Sensorelementen möglichst dicht aneinander zu legen. Ein Mindestabstand zwischen zwei Sensorelementen eines eindimensionalen Sensors ist dabei dadurch vorgegeben, daß in dem neben der Sensorreihe verlaufenden Schieberegister zwischen zwei zur Aufnahme der Ladungspakete aus den Sensorelementen bestimmten Kondensatoren mehrere weitere MIS-Kondensatoren zur Verschiebung der Ladung nötig sind. Von Herbst und Pfleiderer ist in dem Artikel »Modulation Transfer Function of Quadrilinear C. C. D. Imager« (Electronics Letters, Band 12, Nr. 25) eine besonders raumsparende Anordnung angegeben, bei der an jeder Seite der Sensorreihe ein Schieberegister angeordnet ist. Die Sensorelemente sind nun nacheinander einmal mit einem MIS-Kondensator des rechten und einmal einem MIS-Kondensator des linken Schieberegisters über Übertragungselektroden gekoppelt (bilineare Anordnung). Ferner wird vorgeschlagen, an jeder Seite noch ein zweites, paralleles Schieberegister anzuordnen. Jedes zweite Ladungspaket, das in das eine innere, der Sensorreihe unmittelbar benachbarte Schieberegister über eine erste Übertragungselektrode verschoben wird, wird sodann mittels einer zweiten Übertragungselektrode in einen MIS-Kondensator des entsprechenden, parallel laufenden äußeren Schieberegisters weiter geschoben. Der zum Durchschieben des Ladungspaketes aus dem Sensorelement in das äußere Schieberegister benötigte MIS-Kondensator des inneren Schieberegisters kann beim anschließenden Auslesen der Ladungspakete aus den Schieberegistern verwendet werden zum Verschieben der Ladungen längs der Schieberegister (quadrilineare Anordnung).

Bei starkem Lichteinfall auf einzelne Sensorelemente oder eine Gruppe von Sensorelementen kann der Fall eintreten, daß so viel Minoritätsträger optisch erzeugt werden, daß sie in benachbarte Sensorelemente überlaufen (blooming) und zur Zerstörung der Information in größeren Bereichen des Sensors führen. Diese Erscheinung kann verhindert werden, wenn an der Halbleiteroberfläche entgegengesetzt dotierte Überlaufgebiete (Drain-Gebiete) vorgesehen sind, die mit entsprechenden Überlaufelektroden kontaktiert sind und aus den Sensorelementen überlaufende Ladungsträger aus dem Substrat abziehen können. Zwischen den Sensorelementen und den Überlaufgebieten muß jedoch eine Potentialschwelle bestehen, die so hoch ist, daß die Minoritätsträger bei normaler Belichtung am Übertritt ins Überlaufgebiet gehindert werden und erst bei zu starker Belichtung, d. h. wenn nicht mehr alle Minoritätsträger im Sensorelement gespeichert werden können, ins Überlaufgebiet abdiffundieren. Diese Potentialschwelle muß geringer sein als die Potentialschwelle zwischen den einzelnen Sensorelementen und kann dadurch erzeugt werden, daß zwischen den Überlaufgebieten und den Sensorelementen ein zusätzliches Gate angeordnet ist, durch das der Potentialverlauf zwischen Überlaufgebiet und Sensorelektrode gesteuert werden kann. Um dieses Prinzip auf eindimensionale Sensoren anwenden zu können, wird jedoch ein erheblicher Platz für die Überlaufgebiete, Überlaufelektroden und deren Ansteuervorrichtungen benötigt. Dies schränkt das Auflösungsvermögen des Sensors erheblich ein.

Aus DE-A-2 334 116 ist beispielsweise bereits eine Ladungsübertragungs-Baueinheit mit einem Halbleiter-Ladungsspeichermedium, einer Isolierschicht, welche zumindest einen Teil einer Oberfläche des Mediums überdeckt, und einer Anordnung von Metallelektroden an der Schicht zur Bildung örtlich festgelegter Integrationsstellen in dem Medium zwecks Sammlung beweglicher Ladungsträger in Abhängigkeit von auf das Medium fallendem Licht sowie zur Übertragung der beweglichen Ladungsträger in einer Richtung im wesentlichen parallel zu der Oberfläche aus den Integrationsstellen sowie zu einem Ausgangselement, bekannt, die dadurch gekennzeichnet ist, daß ein Ablaufbereich für die beweglichen Ladungsträger neben den Integrationsstellen aufgebaut ist und daß Elemente zum Aufbau eines Potentials in dem Medium in dem Bereich zwischen den Integrationsstellen und dem Ablaufbereich vorgesehen sind, so daß überschüssige bewegliche Ladungsträger in den Integrationsstellen sich zu dem Ablauf bewegen.

Mit dieser bekannten Anordnung ist das zuvor erläuterte, durch starken Lichteinfall verursachte Überlaufen (blooming) verhinderbar. Die Struktur stellt jedoch noch keine optimale Lösung hinsichtlich des Flächenbedarfs dar.

Aus DE-A-2 602 800 ist bereits eine Anordnung bekannt, in der ein Überlaufgebiet vorgesehen ist, das sich seitlich an jedem Sensorelement befindet und sich an einer zur zugehörigen Übertragungselektrode entgegengesetzten Seite des Sensorelementes erstreckt. Mit dieser bekannten Anordnung wird ein Festkörper-Bildsensor geschaffen, bei dem die vertikalen Schieberegister zickzack-förmig angeordnet sind, um den Bereich der Übergangselektrode und damit den Ladungsübertragungswirkungsgrad zu erhöhen.

Der vorliegenden Erfindung liegt die Aufgabe zugrunde, einen optoelektronischen Sensor mit Überlaufvorrichtung der eingangs genannten Art zu schaffen, bei dem die Überlaufvorrichtung derart ausgebildet ist, daß sie eine hohe Packungsdichte der linear angeordneten Sensorelemente gestattet. Aufgabengemäß soll diese hohe Packungsdichte trotz des Umstandes erreicht werden, daß der betreffende optoelektronische Sensor »interdigital« arbeitet, d. h. nach beiden Seiten in zwei getrennte CCD-Anordnungen ausgelesen wird.

Die der Erfindung zugrunde liegende Aufgabe wird durch einen optoelektronischen Sensor mit Überlaufvorrichtung nach dem Oberbegriff des Patentanspruchs 1 gelöst, der dadurch gekennzeichnet ist, daß die Isolierschicht und die Elektroden der Sensorelemente als sich über die ganze Reihe erstreckende Schichten ausgebildet sind, daß in der Umgebung der Sensorelemente zur Erzeugung der Potentialschwellen die Isolierschicht dicker ist als in den Sensorelementen selbst und/oder in die Isolierschicht eine Abschirmelektrode eingebettet ist und/oder ein stärker dotierter Bereich des Halbleiters vom ersten Leitungstyp vorgesehen ist, daß die Elektrodenschicht die Überlaufgebiete überlappt, daß die Abschirmelektrode sich mäanderartig zwischen den Sensorelementen und den Überlaufgebieten erstreckt und daß die Potentialschwelle zwischen Sensorelementen und Überlaufgebieten gegenüber der Potentialschwelle zwischen den Sensorelementen selbst dadurch verringert wird, daß zwischen Sensorelementen und Überlaufgebieten eine gegenüber der Isolierschicht zwischen den Sensorelementen dickere Isolierschicht vorgesehen ist und/oder die Halbleiterkörper-Dotierung zwischen den Sensorelementen von der Halbleiterkörper-Dotierung zwischen Sensorelementen und Überlaufgebieten abweicht.

Die Überlaufgebiete sind — wie dies bereits bekannt ist — über Fenster in der Isolierschicht mit einer Überlaufelektrode kontaktiert. Ferner sind in bekannter Weise Mittel vorgesehen, die zwischen den Überlaufgebieten und den Sensorelementen eine gegenüber der Potentialschwelle zwischen den Überlaufgebieten geringere Potentialschwelle für Minoritätsträger erzeugen.

Zwischen den Sensorelementen untereinander und zwischen den Sensorelementen und den Überlaufgebieten kann eine Potentialschwelle für die Minoritätsträger dadurch erzeugt werden, daß der Halbleiterkörper in diesem Zwischengebiet eine stärkere Dotierung vom gleichen Leitungstyp aufweist wie unterhalb der Sensorelektroden. Man kann in diesem Zwischengebiet aber auch eine Abschirmelektrode (Field shield Gate) anordnen, die von der Halbleiteroberfläche durch eine Isolierschicht getrennt ist. Dadurch kann z. B. für negative Ladungsträger durch eine negative Gate-Spannung eine hohe Potentialschwelle erzeugt werden. Da der Einfluß eines Gate-Potentials auf den Potentialverlauf im Halbleiterkörper mit zunehmender Isolatorschichtdicke zwischen dem Gate und der Halbleiteroberfläche abnimmt, kann ferner die Höhe der Potentialschwelle auch durch die Dicke der Isolatorschicht beeinflußt werden. So können insbesondere die Sensorelektroden als eine durchgehende Schicht ausgebildet werden und die Potentialschwelle zwischen den Sensorelementen durch eine Vergrößerung der Isolatorschichtdicke erreicht werden. Diese Elektrodenschicht kann sich sogar noch über die Überlaufgebiete erstrecken und die Überlaufelektroden selbst bilden, wobei eine Potentialschwelle zwischen den Sensorelementen und dem Überlaufgebiet ebenfalls durch Vergrößerung der Isolator-Schichtdicke erzeugt werden kann.

Somit ergibt sich die vorteilhafte Möglichkeit, die Sensorelektroden als eine sich über die ganze Reihe erstreckende Elektrodenschicht auszubilden. Außerhalb der Sensorelemente ist die Isolierschicht zur Erzeugung der Potentialschwelle dicker als in den MIS-Kondensatoren der Sensorelemente. Zur Erzeugung der Potentialschwelle um die Sensorelemente herum kann ersatzweise oder zusätzlich in die Isolierschicht zwischen der Elektrodenschicht und der Halbleiteroberfläche eine Abschirmelektrode eingebettet sein. Es kann aber auch der Halbleiter im Bereich außerhalb der Sensorelemente eine stärkere Dotierung vom ersten Leitungstyp enthalten als unter den Sensorelektroden selbst. Diese Maßnahmen können sowohl zur gegenseitigen Trennung der Sensorelemente wie zur Trennung zwischen den Sensorelementen und den Überlaufgebieten angewendet werden, wobei sie so dimensioniert werden, daß die Potentialschwelle zwischen Sensorelementen und Überlaufgebieten geringer ist, als die Potentialschwelle zwischen den Sensorelementen untereinander.

Vorzugsweise überlappt die Elektrodenschicht die Überlaufgebiete. Zwischen den Sensorelementen und den Überlaufgebieten windet sich mäanderartig die Abschirmelektrode. Dadurch wird eine besonders hohe Potentialschwelle sowohl zwischen den Sensorelementen untereinander wie zwischen den Sensorelementen und den Überlaufgebieten erzeugt. Die Potentialschwelle zwischen den Sensorelementen und den Überlaufgebieten wird gegenüber der Potentialschwelle zwischen den Sensorgebieten untereinander dadurch verringert, daß zwischen Sensorelementen und Überlaufgebieten eine größere Isolierschichtdicke vorgesehen ist als zwischen den Sensorelementen untereinander. Es kann aber auch der Halbleiterkörper zwischen Sensorelementen und Überlaufgebieten stärker vom ersten Leitungstyp dotiert sein als zwischen den Sensorelementen, oder es können sowohl Dotierung wie Isolierschichtdicke variiert werden.

Anhand zweier Ausführungsbeispiele und sechs Figuren wird die Erfindung näher erläutert. Es zeigt

Fig. 1 den schematischen Aufbau der Dotierungen, Isolierschichten und Elektroden auf einem Ausschnitt der Halbleiteroberfläche bei einem Sensor nach der Erfindung,

Fig. 2 die Dotierung an der Oberfläche des Halbleiterkörpers bei einem bevorzugten ersten Ausführungsbeispiel,

Fig. 3 die Isolierschicht auf der Halbleiteroberfläche,

Fig. 4 die aus einer ersten Polysiliziumlage erzeugten Elektroden,

Fig. 5 die aus einer zweiten Polysiliziumlage erzeugten Elektroden und die Überlaufelektrode bei diesem ersten Ausführungsbeispiel,

Fig. 6 die aus einer zweiten Polysiliziumlage erzeugten Elektroden entsprechend Fig. 5 bei einem bevorzugten Ausführungsbeispiel.

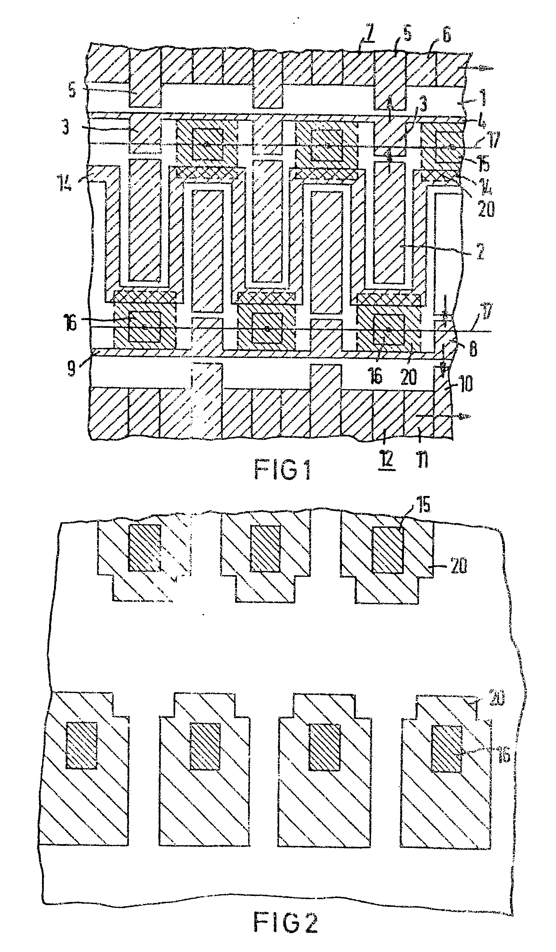

Fig. 1 zeigt zunächst eine Anordnung, die mehrere an sich bekannte Merkmale aufweist. Es ist die Anordnung der dotierten Gebiete und der Elektroden auf der Oberfläche eines Halbleiterkörpers 1 schematisch dargestellt. Mit 2 sind dabei die in einer Reihe angeordneten MIS-Kondensatoren und mit 3 Übertragungselektroden bezeichnet, die über eine Leitung 4 angesteuert werden und aus jedem zweiten Sensorelement 2 die darin befindlichen Ladungspakete in weitere MIS-Kondensatoren 5 verschieben, die zusammen mit anderen MIS-Kondensatoren 6 ein Schieberegister 7 auf der einen Seite der Sensorelementenreihe bilden. Die anderen Sensorelemente 2 sind analog auf der anderen Seite über Übertragungselektroden 8 und deren Taktleitungen 9 mit MIS-Kondensatoren 10 nach dem Prinzip der Ladungskopplung verbunden, wobei diese Kondensatoren 10 zusammen mit weiteren MIS-Kondensatoren ein anderes Schieberegister 12 bilden. Die Verschieberichtung der Ladungspakete aus den Sensorelementen 2 in das Schieberegister 7 und in das Schieberegister 12 sowie innerhalb der Schieberegister sind durch Pfeile dargestellt.

Um im gemeinsamen Halbleiterkörper 1 die Sensorelemente 2 voneinander durch eine Potentialschwelle für die Minoritätsträger zu trennen, ist erfindungsgemäß eine Abschirmelektrode 14 vorgesehen, die sich mäanderförmig um die Sensorelemente 2 windet. Von den Sensorelementen 2 nur durch die Abschirmelektrode 14 getrennt, grenzen an diese Sensorelemente 2 an der den Verschiebeelektroden 3 bzw. 8 entgegengesetzten Seite Überlaufgebiete 15 bzw. 16, die an sich bekannt sind, an, die entgegengesetzt zum Halbleiterkörper dotiert sind und mit Überlaufelektroden in Verbindung stehen, die durch die Linie 17 angedeutet sein sollen. Um die Überlaufgebiete 15 bzw. 16 erstrecken sich Gebiete 20 unter die Abschirmelektrode 14 bis in die Nähe der Sensorelemente 2, bei denen die den Halbleiterkörper bedeckende Isolierschicht dicker ausgebildet ist und zusätzlich eine höhere Dotierung vom Typ des Halbleiterkörpers vorgesehen ist. Dadurch wird die Potentialschwelle zwischen den Überlaufgebieten 15 und den Sensorelementen 2 gegenüber der Potentialschwelle zwischen den Sensorelementen 2 untereinander herabgesetzt.

Der genauere Aufbau eines bevorzugten Ausführungsbeispiels eines Sensors nach der Erfindung ist in den Fig. 2 bis 5 erläutert. Fig. 2 zeigt die Dotierung an der Oberfläche eines Silizium-Halbleiterkörpers. Gegenüber der p-Dotierung von etwa $7 \times 10^{14}$ cm$^{-3}$ des Halbleitersubstrates sind die Bereiche 20 mit $2 \times 10^{16}$ cm$^{-3}$ stärker dotiert. Die Überlaufgebiete 15 und 16 weisen eine starke n-Dotierung, z. B. $10^{19}$ bis $10^{21}$ mit Arsen oder Phosphor, auf.

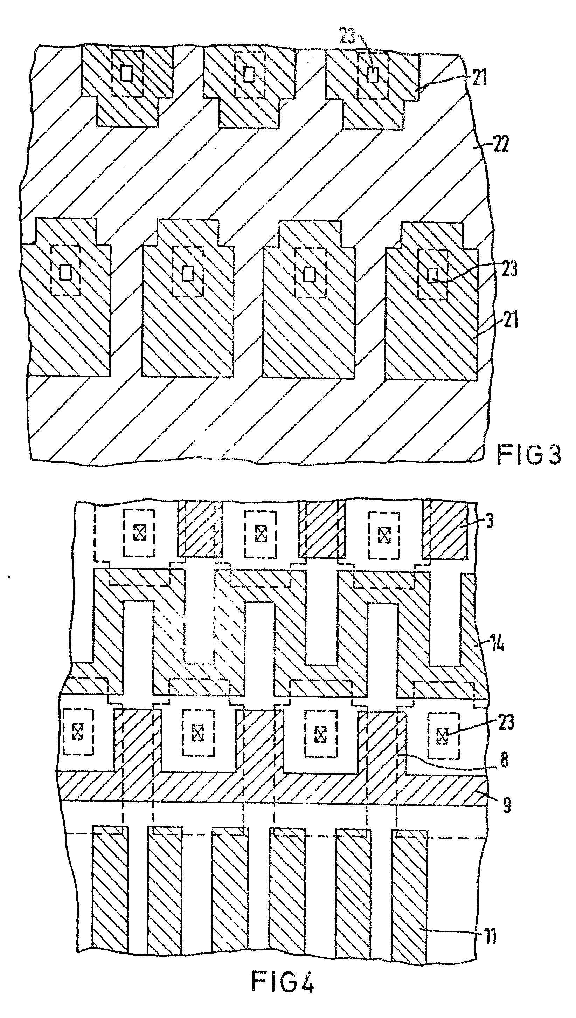

Die Halbleiteroberfläche ist mit einer Isolierschicht, üblicherweise einer Oxidschicht 22, mit einer Dicke von etwa 60 nm bedeckt (Fig. 3). Dabei sind Kontaktfenster 23 zur Kontaktierung der Überlaufgebiete mit den Überlaufelektroden vorgesehen. Ferner ist die Oxidschichtdicke über den Gebieten 20 mit etwa 600 nm stärker gewählt (Feldoxid 21). Die Herstellung der Feldoxidschicht kann zusammen mit der starken Dotierung der Bereiche 20 in einem selbstjustierenden Verfahren hergestellt werden.

Auf diese Isolierschicht wird eine erste Elektrodenschicht, vorzugsweise hochdotiertes Polysilizium, aufgebracht (Fig. 4), aus der die Abschirmelektrode 14, die Übertragungselektroden 3 und 8 mit ihren Ansteuerleitungen 4 und 9 sowie die Elektroden jedes zweiten MIS-Kondensators 6 bzw. 11 der nach dem CCD-Prinzip aufgebauten Schieberegister 7 und 12 ausgeätzt werden. In den Fig. 3 bis 5 sind jeweils die Konturen der vorher aufgebrachten Elemente mit eingezeichnet. Dabei werden die Bemühungen sichtbar, ein Aufeinanderfallen der Kanten zweier übereinanderliegender Lagen zu vermeiden, wodurch sich die genaue Geometrie der Isolatorschichten und Elektrodenschichten ergibt. Über dieser ersten Polysiliziumlage befindet sich — mit Ausnahme der ausgesparten Kontaktfenster 23 für die Überlaufelektroden — eine dünne Oxidschicht, auf der eine zweite Polysiliziumlage aufgebracht ist.

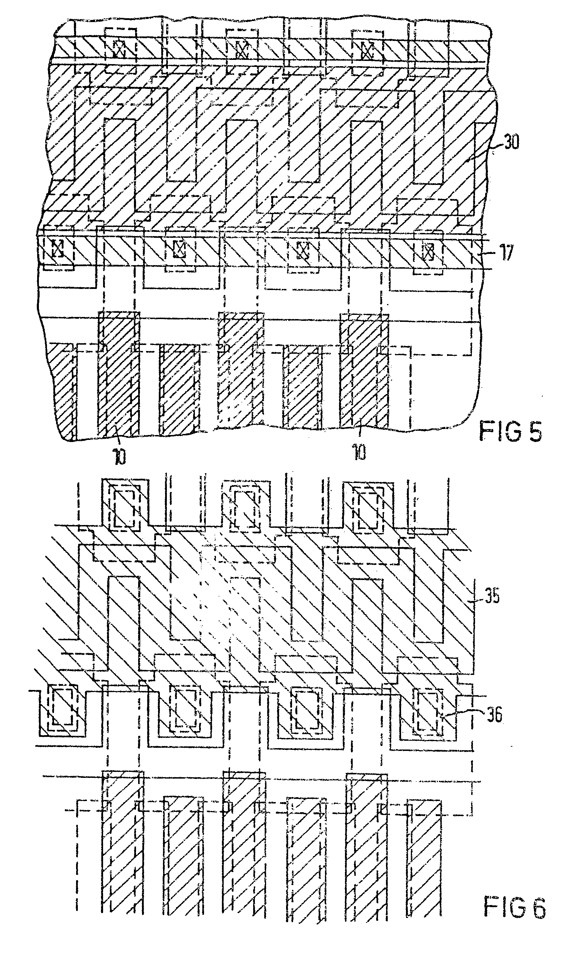

Aus dieser Polysiliziumlage sind, wie in Fig. 5 dargestellt ist, in einem Ätzverfahren die Elektroden der MIS-Kondensatoren 5 und 10 gebildet, die die Übertragungselektroden 3 bzw. 8 überlappen und zur Aufnahme der Ladungspakete aus den Sensorelektroden nach dem Prinzip der Ladungskopplung dienen. Ebenso sind die Elektroden weiterer MIS-Kondensatoren der CCD-Schieberegister und die Sensorelektroden der Sensorelemente 2 aus dieser zweiten Polysiliziumlage gebildet. Die Sensorelektroden werden dabei von einem die Sensorelemente 2 überdeckenden Polysiliziumstreifen 30 gebildet, der als eine gemeinsame Elektrode alle Sensorelemente einschließlich der Abschirmelektrode 14 überdeckt.

Ferner sind in Fig. 5 noch Kontaktleitungen 17 aus Aluminium eingezeichnet, die mit den Überlaufgebieten 16 durch die Kontaktfenster 23 in Verbindung stehen und die Überlaufelektroden bilden. Nicht eingezeichnet sind weitere, zum Betrieb der Schieberegister nötige Steuerleitungen, die ebenfalls aus einem lichtundurchlässigen Material bestehen können und sich seitlich an die Kontaktbahn der Überlaufelektroden anschließen, wobei dadurch gleichzeitig eine Begrenzung des lichtempfindlichen Bereichs des Sensors, also ein Schutz der Übertragungselektroden und Schieberegister vor Belichtung, entsteht.

Beim Betrieb des Sensors liegt die Abschirmelektrode 14 ständig auf negativem Potential, so daß sich darunter eine Akkumulationsschicht von Majoritätsträgern bildet und der Austritt von Minoritätsträgern in dem Bereich unterbunden wird, der unter der Abschirmelektrode liegt. Während der Belichtungszeit zwischen zwei Auslesevorgängen liegen die Sensorelektroden der Kondensatoren 2 auf positivem Potential, es werden also optisch erzeugte Minoritätsträger gesammelt, während die Übertragungselektroden 3 bzw. 8 auf negativem Potential liegen und somit einen Austritt von Minoritätsträgern auch an dieser Seite der Sensorelemente unterbinden. Das Abschirmpotential der Abschirmelektroden wird zwar durch die p$^+$-Dotierung der Bereiche 20 verstärkt, aber durch die Feldoxidschicht derart abgeschwächt, daß bei übermäßiger Belichtung (d. h. wenn durch Ansammlung einer größeren Anzahl optisch erzeugter Minoritätsträger das Potential unter den Sensorelektroden ansteigt) die überschüssigen Minoritätsträger durch den Bereich 20 zum Überlaufgebiet (Drain) 16 abfließen, bevor es zu einem Übertritt von Minoritätsträgern aus einem Sensorelement in ein anderes Sensorelement kommen kann. Die Überlaufelektroden liegen ebenso wie die Sensorelektroden während der Integration der Minoritätsträger auf positivem Potential und ziehen die überschüssigen Minoritätsträger aus dem Substrat ab.

Der Sensor nach der Erfindung benötigt keine zusätzliche Elektroden zur Einstellung der Potentialschwelle zwischen den Sensorelementen und dem Überlauf-Drain. Ferner liegt das Überlaufgebiet nicht direkt zwischen zwei benachbarten Sensorelementen, wo es die Packungsdichte verringern würde, sondern zwischen jeweils zwei übernächsten Nachbarn an der Schmalseite der dazwischenliegenden Sensorelemente, einem Platz, der bei einem bilinearen Sensor ohnehin vorhanden ist und nicht benötigt wird. Ein weiterer Vorteil der Anordnung ist, daß nur in einem sehr geringen Teil der Halbleiteroberfläche ein Dunkelstrom erzeugt werden kann. Von den Akkumulationsschichten unter der Abschirmelektrode und den Übertragungselektroden wird ohnehin nur ein vernachlässigbarer Dunkelstrom erzeugt, so daß ein nennenswerter Dunkelstrom außerhalb der Sensorelemente nur zwischen der Abschirmelektrode und der Übertragungselektrode entstehen könnte. Dort liegt jedoch das Überlauf-Drain und sammelt einen beträchtlichen Anteil des Dunkelstromes auf.

**0 007 384**

Ferner hat es sich gezeigt, daß der direkte Kontakt einer Elektrode auf einem Halbleiterkörper in einer Art »Getter-Wirkung« die thermische Generation von Ladungsträgern an der Oberfläche in der ganzen Umgebung des Kontaktes verringert.

Da die Sensorelektroden und die Überlaufelektrode beide auf positives Potential gelegt werden müssen, ergibt sich die Möglichkeit, sie als einen gemeinsamen Elektrodenstreifen auszubilden.

Fig. 6 zeigt ein derartiges Ausführungsbeispiel, bei dem der Polysiliziumstreifen 35 der zweiten Lage sich unter Überschneidung der Abschirmelektrode sowohl über die Sensorelemente wie über die Überlaufgebiete erstreckt und somit gleichzeitig die Sensorelektroden und die Überlaufelektroden bildet. Dieser Streifen 35 steht demnach über die Kontaktfenster 36, die gegenüber den Kontaktfenstern 23 in Fig. 3 größer ausgebildet sind, mit den Überlaufgebieten flächenhaft in Berührung. Dabei ergibt sich zusätzlich die vorteilhafte Möglichkeit, als Elektrodenschicht mit Phosphor oder Arsen hochdotiertes Polysilizium zu verwenden und die Dotierung der Überlaufgebiete durch Ausdiffusion von Dotierstoff aus dieser Elektrodenschicht zu erzeugen.

Dabei kann man vorteilhaft noch zu einer weiteren Platzeinsparung gelangen, wenn man für den Sensor den eingangs beschriebenen quadrilinearen Aufbau gewählt.

Zur Erzeugung der Potentialschwellen werden bei diesen Ausführungsbeispielen die eingangs erwähnten drei Möglichkeiten, nämlich die Verwendung einer Abschirmelektrode, einer unterschiedlichen Dotierung und einer unterschiedlichen Oxidschichtdicke, kombiniert angewendet. Prinzipiell kann auch eine andere Kombination dieser Möglichkeiten gewählt werden. So könnte z. B. auf die Verwendung einer Abschirmelektrode verzichtet werden und die Potentialschwelle zwischen den Sensorelementen untereinander durch eine höhere p-Dotierung und eine dickere Isolierschicht in den bisher unter der Abschirmelektrode liegenden Bereichen erreicht werden. Durch eine Abschwächung der p-Dotierung oder der Isolierschichtdicke kann die Potentialschwelle zwischen den Sensorelementen und den Überlaufgebieten dann niedriger gewählt werden als die Potentialschwelle zwischen den Sensorelementen selbst. Ebenso könnte zwar mit einer Abschirmelektrode, aber mit einer gleichmäßig dicken Isolierschicht gearbeitet werden, sofern zwischen den Sensorelementen die p-Dotierung stärker und zwischen Sensorelementen und Überlaufgebieten schwächer gewählt wird. Auch in diesen Fällen erreicht man eine Potentialschwelle zwischen den Sensorelementen, die größer ist als die Potentialschwelle zwischen Sensorelementen und Überlauf-Drain, jedoch ist die Trennung der einzelnen Sensorelemente in diesem Fall geringer als in den anhand der Figuren dargestellten Ausführungsbeispielen.

Derartige vereinfachte Ausführungsbeispiele können demnach dann angewendet werden, wenn die Gefahr einer Überbelichtung einzelner Sensorelemente geringer ist.

**Patentansprüche**

1. Optoelektronischer Sensor mit Überlaufvorrichtung, enthaltend eine auf einem dotierten Halbleiterkörper (1) vom ersten Leitungstyp angeordnete Reihe von Sensorelementen (2) aus MIS-Kondensatoren zur Sammlung optisch erzeugter Minoritätsträger, die gegeneinander getrennt sind durch Mittel zur Erzeugung einer Potentialschwelle für die Minoritätsträger im Halbleiterkörper (1), mindestens ein von weiteren MIS-Kondensatoren (5, 6 bzw. 10, 11) gebildetes Schieberegister (7 bzw. 12) auf jeder Seite der Sensorreihe und seitlich an den Sensorelektroden angeordnete Übertragungselektroden (3 bzw. 8), die nach dem Prinzip der Ladungskopplung die Sensorelemente (2) abwechselnd mit einem Kondensator der beiden Schieberegister (7, 12) verbinden, sowie Überlaufgebiete (15, 16), die über Fenster in der Isolierschicht mit einer Überlaufelektrode kontaktiert sind, und Mittel, die zwischen den Überlaufgebieten (15, 16) und den Sensorelementen (2) eine gegenüber der Potentialschwelle zwischen den Sensorelementen (2) selbst geringere Potentialschwelle für die Minoritätsträger erzeugen, wobei die Oberfläche des Halbleiterkörpers (1) seitlich an jedem Sensorelement (2) ein Überlaufgebiet vom zweiten Leitungstyp enthält, das sich an der zur zugehörigen Übertragungselektrode (3, 8) entgegengesetzten Seite des Sensorelementes (2) erstreckt, dadurch gekennzeichnet, daß die Isolierschicht und die Elektroden der Sensorelemente (2) als sich über die ganze Reihe erstreckende Schichten (22, 30) ausgebildet sind, daß in der Umgebung der Sensorelemente (2) zur Erzeugung der Potentialschwellen die Isolierschicht (21) dicker ist als in den Sensorelementen (2) selbst und/oder in die Isolierschicht eine Abschirmelektrode (14) eingebettet ist und/oder ein stärker dotierter Bereich (20) des Halbleiters vom ersten Leitungstyp vorgesehen ist, daß die Elektrodenschicht (22) die Überlaufgebiete (15, 16) überlappt, daß die Abschirmelektrode (14) sich mäanderartig zwischen den Sensorelementen (2) und den Überlaufgebieten (15, 16) erstreckt und daß die Potentialschwelle zwischen Sensorelementen (2) und Überlaufgebieten (15, 16) gegenüber der Potentialschwelle zwischen den Sensorelementen (2) und Überlaufgebieten (15, 16) eine gegenüber der Isolierschicht (22) zwischen den Sensorelementen (2) dickere Isolierschicht (21) vorgesehen ist und/oder die Halbleiterkörper-Dotierung zwischen den Sensorelementen (2) von der Halbleiterkörper-Dotierung zwischen Sensorelementen (2) und Überlaufgebieten (15, 16) abweicht.

2. Sensor nach Anspruch 1, dadurch gekennzeichnet, daß die Elektrodenschicht (35) der Sensorelektroden auch die Überlaufelektroden bildet.

3. Sensor nach Anspruch 1 oder 2, dadurch gekennzeichnet, daß der dotierte Halbleiterkörper aus p-Silizium besteht.

4. Sensor nach einem der Ansprüche 1 bis 3, dadurch gekennzeichnet, daß die Elektroden aus stark dotiertem Polysilizium bestehen.

5. Sensor nach einem der Ansprüche 1 bis 4, dadurch gekennzeichnet, daß die Dotierung der Überlaufgebiete (15, 16) aus Dotierteilchen des zweiten Leitungstyps besteht, die aus den Überlaufelektroden (17) ausdiffundiert sind.

## Claims

1. An opto-electronic sensor having an overflow arrangement, including a row of sensor elements (2) which are arranged on a doped semiconductor body (1) of a first conductivity type, which consist of MIS capacitors, which serve to collect optically-generated minority carriers, and which are separated from one another by means which produce a potential barrier for the minority carriers in the semiconductor body (1); at least one shift register (7 or 12) formed by further MIS capacitors (5, 6 or 10, 11), transfer electrodes (3 and 8) which are arranged on either side of the row of sensors and laterally of the sensor electrodes, and which connect the sensor elements (2) alternately to a capacitor of the two shift registers (7, 12) in accordance with the charge coupling principle; overflow regions (15, 16) which are contacted with an overflow electrode through windows in the insulating layer; and means to produce a potential barrier for the minority carrier between the overflow regions (15, 16) and the sensor elements (2) which is lower than the potential barrier between the sensor elements (2) themselves, the surface of the semiconductor body (1) laterally of each sensor element (2) containing an overflow region of the second conductivity type which extends along that side of the sensor element (2) which is opposite to the associated transfer electrode (3, 8), characterised in that the insulating layer and the electrodes of the sensor elements (2) are in the form of layers (22, 30) which extend along the entire row; that in the vicinity of the sensor elements (2), in order to produce the potential barriers, the insulating layer (21) is thicker than in the sensor elements (2) themselves, and/or a screening electrode (14) is embedded in the insulating layer, and/or a more strongly doped zone (20) of the semiconductor of the first conductivity type is provided; that the electrode layer (22) overlaps the overflow regions (15, 16); that the screening electrode (14) extends in serpentine fashion between the sensor elements (2) and tne overflow regions (15, 16); and that the potential barrier between the sensor elements (2) and the overflow regions (15, 16) is reduced relative to the potential barrier between the sensor elements (2) themselves in that between the sensor elements and the overflow regions (15, 16), there is arranged an insulating layer (21) which is thicker than the insulating layer (22) between the sensor elements (2), and/or the doping of the semiconductor body between the sensor elements (2) differs from the doping of the semiconductor body between the sensor elements (2) and the overflow regions (15, 16).

2. A sensor as claimed in Claim 1, characterised in that the electrode layer (35) of the sensor electrodes also forms the overflow electrodes.

3. A sensor as claimed in Claim 1 or Chlaim 2, characterised in that the doped semiconductor body consists of p-silicon.

4. A sensor as claimed in one of Claims 1 to 3, characterised in that the electrodes consist of strongly doped polysilicon.

5. A sensor as claimed in one of Claims 1 to 4, characterised in that the doping of the overflow regions (15, 16) consists of doping particles of the second conductivity type which have diffused out of the overflow electrodes (17).

## Revendications

1. Détecteur optoélectronique avec dispositif de dépassement de capacité qui comporte une rangée d'éléments détecteurs (2), qui est disposée sur un corps semiconducteur dopé (1) possédant une premier type de conduction et est constituée par des condensateurs MIS pour rassembler des porteurs minoritaires produits optiquement, éléments qui sont séparés les uns par rapport aux autres par des moyens pour produire un seuil de potential pour les porteurs minoritaires dans le corps semiconducteur (1), au moins un registre à décalage (7 ou 12), formé par d'autres condensateurs MIS (5, 6 ou 10, 11), de chaque côté de la rangée de détecteurs, et des électrodes de transfert (3 ou 8) qui sont disposées latéralement au niveau des électrodes des détecteurs et qui, suivant le principe du couplage direct de charge, relient les éléments détecteurs (2) alternativement avec un condensateur des deux registres à décalage (7, 12), ainsi que des régions de dépassement de capacité (15, 16) qui sont mises en contact avec une électrode de dépassement de capacité, par l'intermédiaire de fenêtres dans la couche isolante, et des moyens qui produisent, entre les régions de dépassement de capacité (15, 16) et les éléments détecteurs (2), un seuil de potentiel, plus faible que le seuil de potentiel entre les éléments détecteurs (2) eux-mêmes, pour les porteurs minoritaires, la surface du corps semiconducteur (1) comportant latéralement, au niveau de chaque élément détecteur (2), une région de dépassement de capacité du deuxième type de conduction qui s'étend au niveau du côté de l'élément détecteur (2) qui est opposé à l'électrode de transfert (3, 8) associée, caractérisé par le fait que la couche isolante et les électrodes des éléments détecteurs (2) se présentent sous la forme de couches (22, 30) qui s'étendent sur toute la rangée, qu'autour des éléments détecteurs (2), pour produire les seuils de potentiel, la couche isolante (21) est plus épaisse que dans les éléments détecteurs (2) eux-mêmes et/ou qu'une électrode de blindage (14) est noyée dans la couche isolante et/ou qu'est prévue une région (20) du semiconducteur fortement dopée et possédant le premier type de conduction, que la couche d'électrodes (22) chevauche les régions de dépassement de capacité (15, 16), que l'électrode de blindage (14) s'étend sous forme de méandres entre les éléments détecteurs (2) et les régions de dépassement de capacité (15, 16), et que le seuil de potentiel entre des éléments détecteurs (2) et des régions de dépassement de capacité (15, 16) est réduit par rapport au seuil de potentiel entre les éléments détecteurs (2) eux-mêmes du fait qu'entre les éléments détecteurs (2) et les régions de dépassement de capacité (15, 16) est prévue une couche isolante (21) plus épaisse que la couche isolante (22) entre les éléments détecteurs (2), et/ou le dopage du corps semiconducteur entre les éléments détecteurs (2) diffère du dopage du corps semiconducteur entre des éléments détecteurs (2) et des régions de dépassement de capacité (15, 16).

2. Détecteur suivant la revendication 1, caractérisé par le fait que la couche d'électrodes (35) des électrodes des détecteurs forme également les électrodes de dépassement de capacité.

3. Détecteur suivant la revendication 1 ou 2, caractérisé par le fait que le corps semiconducteur dopé est constitué par du silicium du type p.

4. Détecteur suivant l'une des revendications 1 à 3, caractérisé par le fait que les électrodes sont constituées par du polysilicium fortement dopé.

5. Détecteur suivant l'une des revendications 1 à 4, caractérisé par le fait que le dopage des régions de dépassement de capacité (15, 16) est constitué par des particules de dopage du second type de conduction, qui sont diffusées à partir des électrodes de dépassement de capacité (17).

FIG 1

FIG 2

FIG 3

FIG 4

FIG 5

FIG 6